Europäisches Patentamt

European Patent Office

Office européen des brevets

(19)

(11) Publication number: **0 090 591**
**B1**

# EUROPEAN PATENT SPECIFICATION

(45) Date of publication of patent specification: **02.07.86**

(21) Application number: **83301617.3**

(22) Date of filing: **23.03.83**

(51) Int. Cl.⁴: **G 11 C 11/00, G 11 C 5/00, G 11 C 7/00**

(54) Semiconductor memory device.

(30) Priority: **30.03.82 JP 50085/82**

(43) Date of publication of application:
**05.10.83 Bulletin 83/40**

(45) Publication of the grant of the patent:
**02.07.86 Bulletin 86/27**

(84) Designated Contracting States:
**DE FR GB**

(56) References cited:
**US-A-4 195 356**

**IEEE JOURNAL OF SOLID-STATE CIRCUITS,
vol. SC-14, no. 5, October 1979, pages 823-828,
New York, USA , M. AKIYA et al.: "New
input/output designs for high speed static
CMOS RAM"**

(73) Proprietor: **FUJITSU LIMITED
1015, Kamikodanaka Nakahara-ku
Kawasaki-shi Kanagawa 211 (JP)**

(72) Inventor: **Aoyama, Keizo
11-28, Tsukimino 1-chome
Yamato-shi Kanagawa 242 (JP)**
Inventor: **Yamauchi, Takahiko
Iseya-so 2F-1 49, Kitaya-cho Nakahara-ku
Kawasaki-shi Kanagawa 211 (JP)**
Inventor: **Seki, Teruo
Dai-2 Yayoi-so 5 5-2, Shimoshinjo 3-chome
Nakahara-ku Kawasaki-shi Kanagawa 211 (JP)**

(74) Representative: **Fane, Christopher Robin King
et al
HASELTINE LAKE & CO. Hazlitt House
28 Southampton Buildings Chancery Lane
London, WC2A 1AT (GB)**

Courier Press, Leamington Spa, England.

## Description

### Background of the invention

#### (1) Field of the invention

The present invention relates to a semiconductor memory device. More particularly, it relates to a semiconductor memory device, such as a metal-insulator semiconductor (MIS) memory device, in which the access time is reduced by increasing the speed of transferring signals from a bit line to a data bus.

#### (2) Description of the prior art

Generally, in an MIS semiconductor memory device, memory cells are arranged in a matrix, and some of the memory cells disposed in a column are selected by a row decoder and are connected to corresponding bit lines. One of the bit lines is selectively connected to data buses through transfer gates controlled by a column decoder, and readout data is derived from the data buses. Therefore, the performance of the transfer gates, such as the rising speed of the transfer gates when they change from a turned off condition to a turned on condition, influences the access time of the MIS semiconductor memory device.

In a conventional MIS semiconductor memory device, transfer gates arranged between bit lines and data buses are constituted of enhancement-type transistors having the same threshold voltage as transistors which are used in other circuits of the memory device. Therefore, in the conventional memory device, the threshold voltage of the transistors constituting the transfer gates is relatively high and the transistors are not turned on until the gate-source voltage of the transistors reaches a level high enough so that the transistors are not turned on until a column-selecting signal applied thereto from a column decoder reaches a relatively high level. Consequently, the speed of transferring information from the bit lines to the data buses cannot be high, thus making the access time of the conventional semiconductor memory device long.

### Summary of the invention

In order to eliminate the disadvantages of the aforementioned conventional device, in accordance with one embodiment of the present invention, the transfer gates disposed between bit lines and data buses in an MIS semiconductor memory device are made from enhancement-type transistors having a low threshold voltage.

It is the principal object of the present invention to make the speed of transferring information from the bit lines to the data buses high and to reduce the access time of the memory device.

The object of the present invention is achieved by providing a semiconductor memory device comprising bit lines, word lines, memory cells arranged at the intersections of the bit lines and the word lines, data buses, and transfer gate transistors connected between the bit lines and the data buses, an information signal being read out to the data buses from the memory cells through the bit lines by turning on the transfer gate transistors, characterized in that the transfer gate transistors have a threshold voltage smaller than that of the transistors used in the other circuits of the semiconductor memory device.

### Brief description of the drawings

Figure 1 is a partial schematic block circuit diagram illustrating an MIS semiconductor memory device which is the embodiment of the present invention;

Fig. 2A is a waveform diagram illustrating the operation of a conventional semiconductor memory device; and

Fig. 2B is a waveform diagram illustrating the operation of the semiconductor memory device of Fig. 1.

### Description of the preferred embodiment

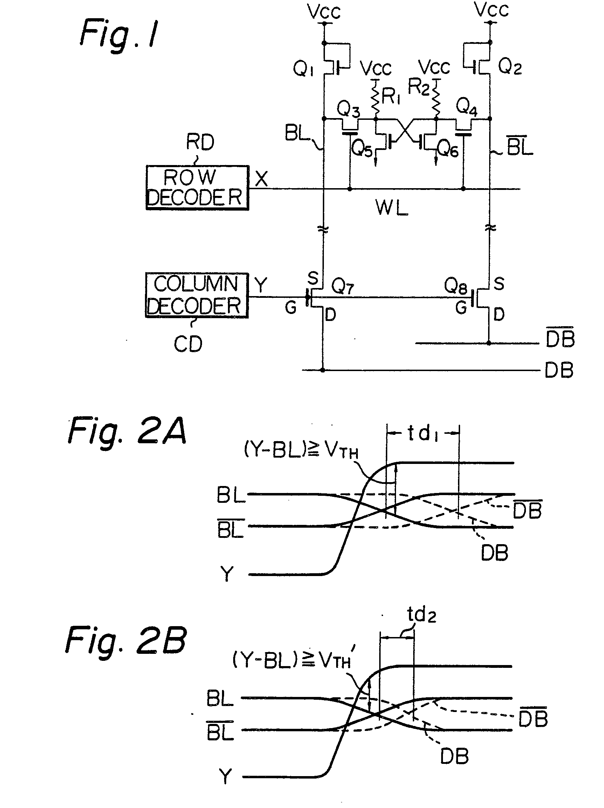

The embodiment of the present invention will now be explained with reference to the drawings. Figure 1 partially illustrates the structure of an MIS semiconductor memory device which is the embodiment of the present invention. In Fig. 1, BL and $\overline{BL}$ designated a pair of bit lines connected to a power source $V_{CC}$ through load transistors $Q_1$ and $Q_2$, respectively. Transistors $Q_3$ through $Q_6$ and resistors $R_1$ and $R_2$ constitute a so-called flip-flop type of memory cell, and the transistors $Q_3$ and $Q_4$ constitute gate circuits which connect the memory cell and the bit line pair BL and $\overline{BL}$. The gate of the transistor $Q_3$ and the gate of the transistor $Q_4$ are connected to a word line WL which is connected to a row decoder RD. The bit lines BL and $\overline{BL}$ are connected to data buses DB and $\overline{DB}$, which constitute a data bus pair, through transistors $Q_7$ and $Q_8$, each of which constitutes a transfer gate, respectively. The gate of the transistor $Q_7$ and the gate of the transistor $Q_8$ are connected to the output terminal of a column decoder CD. The threshold voltage of the gate-source voltage of the transistors $Q_7$ and $Q_8$ is lower than that of the enhancement-type transistors used in other circuits of the semiconductor memory device of Fig. 1. In general, the threshold voltage of the enhancement-type transistors used in a semiconductor device such as the semiconductor device of Fig. 1 is, for example, 0.7 through 0.9 volt, but the threshold voltage of the transistors $Q_7$ and $Q_8$ of Fig. 1 is selected to be a value greater than or equal to zero but less than the above-mentioned values. For example, the threshold voltage of the transistors $Q_7$ and $Q_8$ is selected to be a value between zero and 0.5 volt.

Operation of the circuit of Fig. 1 is now explained. When information is read out of a memory cell, the potential of the word line WL corresponding to the memory cell is rendered to be high and the signals from the memory cell are transmitted to the bit lines BL and $\overline{BL}$ through the transistors $Q_3$ and $Q_4$. At nearly the same time, the transistors $Q_7$ and $Q_8$ constituting the transfer gates are turned on by the column decoder CD.

Thus, the information stored in the memory cell is transmitted from the bit lines BL and $\overline{BL}$ to the data buses DB and $\overline{DB}$ and is output therefrom through a sense amplifier (not shown).

As is illustrated in Fig. 2A, in the conventional memory device, since the threshold voltage of the transistors corresponding to the transistors $Q_7$ and $Q_8$ is large, the time interval $td_1$ between the time when the voltage of the bit line BL and the voltage of the bit line $\overline{BL}$ intersect each other after the signal voltages from the memory cell are transmitted to the bit lines BL and $\overline{BL}$ by the row decoder RD and the time when the voltage of the data bus DB and the voltage of the data bus $\overline{DB}$ intersect each other after changes in the voltage of the bit line BL and the voltage of the bit line $\overline{BL}$ are transmitted to the data buses DB and $\overline{DB}$ is relatively long. That is, the transistors $Q_7$ and $Q_8$ are turned on after the output voltage Y of the column decoder CD rises enough so that the difference between the output voltage Y and the voltage of the bit line BL exceeds the threshold voltage of the gate-source voltage of the transistors $Q_7$ and $Q_8$. After the turning on of the transistors $Q_7$ and $Q_8$, the voltage of bit line BL and the voltage of the bit line $\overline{BL}$ are transmitted to the data buses. However, in the conventional memory device, since the threshold voltage of the gate-source voltage of the transistors $Q_7$ and $Q_8$ is large, the transistors $Q_7$ and $Q_8$ are not turned on until the difference between the output voltage of the column decoder CD and the voltage of the bit line BL becomes relatively large. Therefore, the transistors $Q_7$ and $Q_8$ are turned on after a relatively long time has elapsed since the beginning of the rise of the output voltage of the column decoder CD, and thus the access time of the conventional memory device is relatively long.

On the other hand, in the memory device according to the present invention, since the threshold voltage of the transistors $Q_7$ and $Q_8$ is low, the difference between the output voltage Y of the column decoder CD and the voltage of the bit line BL is larger than the threshold voltage of the transistors $Q_7$ and $Q_8$ a short time after the output voltage Y of the column decoder CD starts to rise, as is illustrated in Fig. 2B. Therefore, the transistors $Q_7$ and $Q_8$ are turned on rapidly and changes in the voltage of the bit line BL and the voltage of the bit line $\overline{BL}$ are rapidly transmitted to the data buses DB and $\overline{DB}$ so that the time interval $td_2$ between the intersection of the bit line voltages and the intersection of the data bus voltages is very small. Since the threshold voltage of the transistors $Q_7$ and $Q_8$ is relatively small, it is possible to make the mutual conductance gm of each transistor larger than that of each transfer gate transistor of the conventional memory device and to increase the speed of transferring information from the bit lines to the data buses. In the above description, the MIS static-type random access memory device is explained by way of example. However, the present invention is not limited to such a memory device. Rather, it is adaptable to all memory devices comprising transfer gate transistors disposed between bit lines and data buses.

As was mentioned above, according to the present invention, it is possible to increase the speed of transferring information from bit lines to data buses without changing the circuit structure and to shorten the access time of a semiconductor memory device.

**Claims**

1. A semiconductor memory device comprising bit lines (BL, $\overline{BL}$), word lines (WL), memory cells arranged at the intersections of said bit lines and said word lines, data buses (DB, $\overline{DB}$) and transfer gate transistors ($Q_7$, $Q_8$) connected between said bit lines and said data buses, an information signal being read out to said data buses from said memory cells through said bit lines by turning on said transfer gate transistors, characterized in that said transfer gate transistors ($Q_7$, $Q_8$) have a threshold voltage smaller than that of the transistors used in the other circuits of said semiconductor memory device.

2. A semiconductor memory device according to claim 1, wherein said semiconductor memory device is an MIS memory device and said transfer gate transistors are MIS transistors.

3. A semiconductor memory device according to claim 2, wherein said transfer gate transistors are MIS transistors whose threshold voltage is smaller than that of the enhancement-type transistors used in the other circuits of said semiconductor memory device.

4. A semiconductor memory device according to claim 2 or 3, wherein said transfer gate transistors have a threshold voltage which is equal to or greater than zero.

5. A semiconductor memory device according to claim 4, wherein said transfer gate transistors have a threshold voltage of between zero and 0.5 volt.

**Patentansprüche**

1. Halbleiterspeichervorrichtung mit Bitleitungen (BL, $\overline{BL}$), Wortleitungen (WL), Speicherzellen, die an den Kreuzungspunkten der genannten Bitleitungen und der genannten Wortleitungen angeordnet sind, Datenbussen (DB, $\overline{DB}$) und Transfergatetransistoren ($Q_7$, $Q_8$), die zwischen den genannten Bitleitungen und den genannten Datenbussen angeschlossen sind, bei welcher ein Informationssignal von den genannten Speicherzellen durch die genannten Bitleitungen durch Einschalten der genannten Transfergatetransistoren zu den genannten Datenbussen ausgelesen wird, dadurch gekennzeichnet, daß die genannten Transfergatetransistoren ($Q_7$, $Q_8$) eine kleinere Schwellenwertspannung als die Transistoren haben, die in den anderen Schaltkreisen der genannten Halbleiterspeichervorrichtung verwendet sind.

2. Halbleiterspeichervorrichtung nach Anspruch 1, bei welcher die Halbleiterspeichervorrichtung eine MIS - Speichervorrichtung und die Transfergatetransistoren MIS-transistoren sind.

3. Halbleiterspeichervorrichtung nach Anspruch 2, bei welcher die genannten Transfergatetransistoren MIS-Transistoren sind, deren Schwellenwertspannung kleiner als diejenige der Transistoren vom Anreicherungstyp sind, die in den anderen Schaltkreisen der Halbleiterspeichervorrichtung verwendet sind.

4. Halbleiterspeichervorrichtung nach Anspruch 2 oder 3, bei welcher die genannten Transfergatetransistoren eine Schwellenwertspannung haben, die gleich oder größer als null ist.

5. Halbleiterspeichervorrichtung nach Anspruch 4, bei welcher die genannten Transfergatetransistoren eine Schwellenwertspannung zwischen null und 0,5 Volt haben.

**Revendications**

1. Dispositif de mémoire à semiconducteurs comprenant des lignes de bit (BL, $\overline{BL}$), des lignes de mot (WL), des cellules de mémoire disposées aux intersections desdites lignes de bit et desdites lignes de mot, des bus de données (DB, $\overline{DB}$), et des transistors portes de transfert ($Q_7$, $Q_8$) connectés entre lesdites lignes de bit et lesdits bus de données, un signal d'informations étant fourni auxdits bus de données en provenance desdites cellules de mémoire par l'intermédiaire desdites lignes de bit par le passage à l'état conducteur desdits transistors portes de transfert, caractérisé en ce que lesdits transistors portes de transfert ($Q_7$, $Q_8$) ont une tension de seuil plus petite que celle des transistors utilisés dans les autres circuits dudit dispositif de mémoire à semiconducteurs.

2. Dispositif de mémoire à semiconducteurs selon la revendication 1, où ledit dispositif de mémoire à semiconducteurs est un dispositif de mémoire MIS et lesdits transistors portes de transfert sont des transistors MIS.

3. Dispositif de mémoire à semiconducteurs selon la revendication 2, où lesdits transistors portes de transfert sont des transistors MIS dont la tension de seuil est plus petite que celle des transistors du type enrichissement utilisés dans les autres circuits dudit dispositif de mémoire à semiconducteurs.

4. Dispositif de mémoire à semiconducteurs selon la revendication 2 ou 3, où lesdits transistors portes de transfert ont une tension de seuil qui est supérieure ou égale à zéro.

5. Dispositif de mémoire à semiconducteurs selon la revendication 4, où lesdits transistors portes de transfert ont une tension de seuil comprise entre zéro et 0,5 V.

*Fig. 1*

*Fig. 2A*

*Fig. 2B*

1